# EUROPEAN PATENT SPECIFICATION

(11) **EP 0 506 593 B1**
(45) Date of publication and mention of the grant of the patent: **07.10.1998**
(21) Application number: 92480023.8
(22) Date of filing: 11.02.1992
(51) Int. Cl.: G03F 7/004, G03F 7/022

(54) **Uniformly coated photoresist compositions**
Gleichmässig beschichtete Photolackzusammensetzung
Compositions photoréserves à enrobage uniforme

(30) Priority: 27.03.1991 US 676141
(43) Date of publication of application: 30.09.1992
(73) Proprietor: International Business Machines Corporation, Armonk, N.Y. 10504 (US)
(72) Inventor: Cornett, Kathleen Marie, Wappingers Falls, NY 12590 (US); Hefferon, George Joseph, Fishkill, New York 12524 (US); Montgomery, Melvin Warren, New Windsor, NY 12553 (US); Moreau, Wayne Martin, Wappingers Falls, NY 12590 (US)
(74) Representative: Klein, Daniel Jacques Henri

(56) References cited:
- EP-A- 211 667
- EP-A- 273 026
- EP-A- 328 824
- EP-A- 336 605
- CHEMICAL ABSTRACTS, vol. 108, no. 20, 16 May 1988, Columbus, Ohio, US; abstract no. 176978N, ROSENTHAL ET AL.: 'CHOOSING POLYMER SOLVENTS FOR MICROLITHOGRAPHY'

## Description

The invention relates to improved photoresist compositions, and more particularly to photoresist compositions which are more uniformly coatable over substrates which have even or uneven topography.

Photoresist materials have taken a very important place in the fabrication of semiconductor (S/C) devices, packaging, and related components. Presently the highest degree of integration lies with S/C devices. The resist compositions used may be positive or negative and may further be classified as to the resin or polymer system employed to transfer images or patterns. Such systems which are deposited or coated onto a substrate typically comprise a resin or polymer matrix whose solubility towards a solvent-often an aqueous alkaline aeveloper, but also polar and nonpolar organic solvents--is altered by the action of radiation on a sensitizer included in the composition which responds to a particular wavelength or form of radiation to permit the transfer of a pattern either through a mask or a writing mechanism into the resin or polymer matrix. The sensitizer is often referred to as a photo active compound (PAC) especially when the sensitizing radiation is visible or ultraviolet light. Other materials will be included in the solids portions of such compositions to perform desired functions or to act as fillers. Finally, in order to be able to form usable compositions which may be coated onto the substrates which are to be patterned it is necessary to have one or more solvents to serve as the vehicle to mix, carry, and coat the resist solids. The solvents are selected for their compatibility with the resist solids and their inertness to the substrates. The coated resist composition is baked or otherwise treated so that the composition is tacky and less fluid.

Photoresist compositions, both positive and negative working, particularly those compositions containing novolak resins, polyhydroxystyrene, and naphthoquinone diazides, are well known to those skilled in the art. See, for example the novolak photoresist compositions which comprise formulations of phenol-formaldehyde resin and a naphthoquinone diazide as described in U.S. Patents Nos. 3,666,473, 4,377,631, and 4,397,937. U. S. Patent No. 4,397,937 to Clecak et al. is directed to improved positive resist compositions having a soluble phenolic resin and a sensitizer which is a diester of a 1-oxo-2-diazonaphthalene sulfonic acid and an unsymmetrical primary or secondary aliphatic diol. Casting solvents for such compositions include conventional solvents such as diglyme, methyl isobutylketone, ethyl cellosolve acetate and the like and mixtures thereof. The naphthoquinone diazides act as dissolution inhibitors resistant to the action of aqueous alkaline developers. Other dissolution inhibitors can be formulated from polymeric materials such as polyolefin sulfones as described in U.S. Patent No. 4,398,001. U. S. Patent No. 4,398,001 to Cheng et al. is directed to electron beam and x-ray sensitive resist compositions comprising mixtures of novolak resins and certain polyolefin sulfone terpolymers. The sensitizer is a terpolymer of sulfur dioxide, an olefinic hydrocarbon and an unsaturated ether. The casting solvent for such composition was 85% cellosolve acetate, 10% n-butyl acetate, and 10% mixed xylene. Another class of resists is based upon acid catalyzed initiators admixed with acid labile polymers as described in U.S. Patent No. 4,491,628. U. S. Patent No. 4,491,628 to Ito et al. is directed to resist compositions which comprise a polymer having recurrent aromatic rings having recurrent pendent groups that undergo efficient acidolysis to produce products of a very different polarity (solubility) than the starting polymer. The sensitizer is a substance which generates a strong acid upon exposure to radiation. The use of diglyme or cyclohexanone as a casting solvent is disclosed and U.S. Patent Application, Serial No. 07/322,848, filed March 14, 1989, Attorney Docket No. FI9-88-046. All of the above resist formulations are useful in semiconductor circuit formulation using the resist material as the radiation sensitive component.

The most widely used form of radiation involves photon exposure to light in the wavelength range of 200-500 nm. In particular, monochromatic light is used at 248 nm (deep UV or DUV), 365 nm (i-line), and 436 nm (g-line) near UV exposure. Monochromatic light exposure involves projection of light onto reflective surfaces with topographies of oxides or other insulators. For film thicknesses of the order of 500-1500 nm, variations in the resist thickness of the order of +/- 10 nm can cause the reflectivity to vary by factors of more than 40% and thus cause the resist linewidth to vary greater than 0.1 um for images on the order of 1 um or less. (M. Bolsen et al., Solid State Technology, Feb. 1986, p. 83 et seq.) Secondly, for optical alignment considerations, submicrometer images exposed by optical steppers require resist films to be as uniform as +/- 10 nm in order to avoid overlay errors in a stepper which constantly senses alignment marks below a resist film. (D. Angel, Semiconductor International, April 1983, p. 72 et seq.). The relation between resist thickness and line width variations has been well documented, and the use of contrast enhancement material and dyed photoresists has been proposed to overcome such problems. (T. Hashimoto et al., SPIE Vol.920 Advances in Resist Technology and Processing V (1988), p. 427 et seq.) Thus highly uniform resist films are desirable to minimize linewidth fluctuations, for proper overlay and alignment, and for increased semiconductor circuit productivity.

The resist films for semiconductor fabrication are usually cast by applying liquid resist droplets to the surface of a silicon wafer either in a dynamic or static mode, followed by spinning the wafer at a speed on the order of 200-5000 rpm for 10-200 seconds. The thickness of the film is controlled by the solid content of the liquid resist, the viscosity of the composition, the spinspeed of the spinner, and the evaporation rate of the liquid. Common solvents described in the patent literature include mixtures of 2-ethoxy-ethyl-acetate (Cellosolve Acetate), n-butyl acetate (NBA), xylene, propylene Solvents such as propylene glycol methyl ether acetate have been used in this respect. The use of propylene glycol methyl ether (PM) is described in U.S. Patent No. 4,948,697, and the use of propylene glycol methyl ether acetate (PMA) is described in U.S. Patent No. 4,550,069. Propylene glycol ethers and acetates are used as solvents which can increase photospeed by 5-10%. The casting solvents are also selected to solubilize the resist components and retain the components in solution over a reasonable shelf-life period.

European Patent Application 0 211 667 to Japan Synthetic Rubber Co., Ltd. discloses radiation sensitive resin compositions which comprise an alkali-soluble resin and a radiation sensitive compound in a solvent comprising a monooxymonocarboxylic acid ester. Such compositions are found to have greatly improved storage stability due to the lack of particle formation during storage and are well suited for use as resists in the manufacture of integrated circuits. The monooxymonocarboxylic acid ester has the formula R¹-O-R²-COOR³ where R¹ is hydrogen, an alkyl group having 1-3 carbon atoms or an acyl group having 1-4 carbon atoms, where R² is an alkylene group having 1-4 carbon atoms, and where R³ is an alkyl group having 1-4 carbon atoms. The alkali-soluble resins include novolak resins (phenol aldehyde acid catalyzed condensation polymers).

The radiation sensitive compounds include 1,2-quinonediazide and azide compounds. The developer for such radiation sensitive resin compositions may include a surfactant or surfactants may be added to such compositions to improve coatability and striation of the radiation-sensitive resin composition. Included within the classes of surfactants are nonionic surfactants such as polyoxyethylene alkyl ethers, polyoxyethylene alkyl phenol ethers, polyethylene glycol dialkyl ethers, fluorine containing surfactants including Fluorad FC 430, organosiloxane polymers and acrylic or methacrylic (co)polymers.

U. S. Patent No. 4,943,511 to Lazarus et al. is directed to positive photosensitive compositions comprising a photosensitizer which is a mixture of mono-, di-, and triesters of a 1,2-naphthoquinone-2-diazo-4-sulfonic acid with 2,3,4-trihydroxybenzophenone. Ethyl-3-ethoxy propionate (EEP) is among the solvents disclosed for use with such compositions. EEP is preferred over ethyl Cellosolve acetate (ECA) because it exhibits lower toxicity. EEP is particularly preferred in that it provides a more stable environment for the components, and provides better particulate stability, i.e., the tendency to form particles in the resist upon storage is reduced. The use of EEP alone also produces striation-free coatings which have a more reproducible photospeed than, for example, the solvents which are three component mixtures.

U.S. Patent No. 4,965,167 to Salamy is directed to light-sensitive compositions which comprise an admixture of (a) at least one alkali-soluble binder resin, (b) at least one photoactive compound, and (c) a solvent mixture comprising ethyl lactate and ethyl-3-ethoxypropionate. Those compositions had inferior coating properties to ethyl Cellosolve acetate, but were desired because such compositions were considsered to be environmentally less hazardous to use than ethyl Cellosolve acetate.

In order to provide manufacturing or process conditions which are as safe for the operators as possible, the solvent system should be of low toxicity and be of low flammability for handling and dispensing. For low cost, a single solvent system is preferred.

In the spin coating and subsequent film forming process, the solvent portion of the resist formulation should have the capacity to wet a primed substrate surface and after spinning level to form a uniform film as the resist composition dries. The residual solvent left after baking should not reduce the photospeed of the exposed resist. The evaporation rate of the solvent from the film should not be too fast to avoid film irregularity or too high to cause trapped solvent whicn may lower sensitivity and result in shallow profiles.

This invention provides uniformly coatable polymeric compositions as defined in claim 1, and especially a uniformly coatable resist composition and a method for producing a uniform film from such compositions. The resist compositions comprise at least one resin selected from the group consisting of novolaks and polyvinyl phenol copolymers, as a photoactive component a diazoquinone sulfony ester of 4,8-bis(hydroxymethyl)-tricyclo-[5.2.1.0^{2,6}] decane, and a solvent of ethyl-3-ethoxy propionate (EEP); coating such compositions by spin coating, drying such composition to a solvent content of less than 10% by weight of he film, imaging, exposing to patterned radiation, developing such images with an aqueous alkaline developer. The other coatable polymer compositions comprise a polymer which is compatible with EEP and EEP.

The present invention provides an improved photoresist composition which enables the improved uniform coating of substrates over a wider range of coating conditions than has been possible with previous known photoresist compositions. Films cast from the photoresist compositions of the invention exhibit substantially uniform photospeed, plasma etch rate, and contrast over the surface of the substrates coated. Considerable savings in the number of viscosity grades (solids content) of resist formulations necessary to coat films in the range of 0.5-3 um for large 200 mm diameter wafers are also evident. Savings on the amount of dispensed resist liquid necessary to spin coat large wafers are also achieved. A single solvent resist also facilitates recycling of the resist collected from spin coating. The viscosity is adjusted by adding more solids or solvent. The solvent is present in an amount of from 40-99.9% by weight of the resist compositions. (In two component solvent systems, the collected resist has to be analyzed for composition before adjustments.) It has been found unexpectedly that improved resist compositions may be formulated with a variety of polymeric and molecular resist components.

Additionally, compositions for uniformly coating polymeric films such as planarizing layers, antireflective coatings, and protective coatings may be prepared using EEP and a polymer which is soluble in EEP.

In a preferred embodiment, the invention uses positive working photoresist compositions which comprise a novolak resin, the photoactive component of claim 1 and a sufficient amount of ethyl-3-ethoxy propionate to form an homogenous composition. Such photoresist composition, in addition to providing more uniform films over the prior art, exhibits a high degree of resolution, good development properties, high contrast, and good adhesion.

The novolak resins used in preparing photosensitive compositions are well known in the art (U. S. Patent No. 4,377,631). The diazoquinone sulfonyl ester of 4,8-bis(hydroxymethyl)-tri- cyclo[5.2.1.0^{2,6}]decane (TDQ) as disclosed in U. S. Patent No. 4,397,937.

In a preferred embodiment of the present invention, the solids part of the resist composition, that is, the resin ranges from 15-95% of resist by weight and the quinone diazide of claim 1 from 5-50% by weight. A more preferred range would be from about 65-95% by weight of resin and from 5-35% by weight of the quinone diazide. In manufacturing the resist, the EEP solvent is present from about 40-99.9% by weight of the resist solids. Uniform, ultra thin (less 5-10 um) coatings may be prepared when less than 1% down to as little as 0.1% resist solids are present. Additives such as colorants, dyes, contrast enhancing agents, antistriation agents, plasticizers, adhesion promoters, speed enhancers, and surfactants, may be added to the solution of the resin, sensitizer, and solvent before the solution is coated on a substrate. Examples of these additives can be found in U. S. Patent No. 4,377,631.

The photoresist coatings formed by the above described embodiment are suitable for application to thermally grown oxides, silicon nitrides, aluminum, or even polymeric films. The resist film after spin coating to a thickness of up to 5 um is baked at temperatures in the range of 85-150°C depending on the components with a preferred range of 90-110°C for quinone diazide resist. After prebaking, the resist film is exposed to suitable ultraviolet, electron beam, ion beam or x-ray radiation. The exposed film may be given a post-exposure (pre-develop bake) at 90-125°C to remove standing waves or complete the latent image chemical reaction. The film is then developed in suitable alkaline developers. The imaged film may be post baked after development to improve adhesion and etch resistance. Finally, the resist is used as an etch or lift-off mask for pattern transfer.

The following examples provide details illustrative of the superior performance of EEP cast formulations over prior art. Superiority is achieved in film uniformity over a wider range of spin rpm. These examples are not intended to limit the scope of the invention and should not be construed as providing conditions or values which must be utilized exclusively to practice the invention.

### Example 1

A diazoquinone formulation according to U. S. Patent No. 4,397,937 of triscyclodecane diol sulfonyl ester of quinone diazide (TDQ) was formulated with EEP, PMA and PMM (propylene glycol methyl ether). A surfactant of 250 ppm Fluorad FC 430 (3M) was added to all samples.

| Solvent | Wt. % Solvent | TDQ Wt. % | Novolak Wt. % |
|---|---|---|---|
| EEP | 71.0 | 5.2 | 23.8 |
| PMA | 75.0 | 4.5 | 22.1 |
| PMA/PMM (50/50) | 76.0 | 4.3 | 19.7 |

Silicon wafers (200 mm) were spin coated on a MTI spin coater at rpm from 1000-5000 rpm and the thickness measured at nine points across the wafer with a Nanospec FTA to determine uniformity.

| Casting Solvent | RPM | Thickness(A) | Uniformity(3s)in A |
|---|---|---|---|
| EEP | 1000 | 21,679 | 151 |
| PMA | 1000 | 22,735 | <900 |
| PMA/PMM | 1000 | 23,459 | <900 |
| | | | |
| EEP | 2000 | 15,236 | 61 |
| PMA | 2000 | 14,767 | 574 |
| PMA/PMM | 2000 | 15,831 | 641 |
| | | | |
| EEP | 3000 | 12,579 | 45 |
| PMA | 3000 | 11,367 | 131 |
| PMA/PMM | 3000 | 12,989 | 145 |
| | | | |
| EEP | 4000 | 9,863 | 41 |
| PMA | 4000 | 10,234 | 98 |
| PMA/PMM | 4000 | 10,985 | 121 |
| | | | |
| EEP | 5000 | 9,216 | 35 |
| PMA | 5000 | 9,543 | 68 |
| PMA/PMM | 5000 | 9,731 | 89 |

The photospeed of EEP and PMA films coated on a silicon wafer to 10,450 A for both formulations and the photospeed was measured on a GCA stepper at 365 nm exposure.

| Solvent | Dose to Print Equal 0.7 um lines & spaces | Profile |
|---|---|---|
| EEP | 0.92 sec | 86 |
| PMA | 0.91 sec | 85 |

The contrast of PMA and EEP formulations was 3.9 and 3.8 respectively, within experimental error. The etch rates were measured in a reactive ion etch system using CF₄ gas and they were equal for the EEP and PMA films.

### Example 2

Formulations of a diazoquinone according to U. S. Patent Application, Serial No. 07/606652, filed October 31, 1990, Attorney Docket No. FI9-90-026, consisting of 17.9% by weight of solids of TDQ, 7.1% by weight of solids of MDT (trifluorosulfonyloxybicyclo[2.2.1]-hept-5-ene-2,3-dicarboximide) and about 75% by weight of solids of novolak resin with 250 ppm FC-430 Fluorad (3M) surfactant were formulated in EEP and PMA and spun cast on 200 mm wafers and the film uniformity was measured.

| Casting Solvent | RPM | Thickness(A) | Uniformity(3s)in A |
|---|---|---|---|
| EEP | 2500 | 13,564 | 47 |
| PMA | 2500 | 13,918 | 308 |
| | | | |
| EEP | 3000 | 11,368 | 43 |
| PMA | 3000 | 12,769 | 136 |
| | | | |
| EEP | 4000 | 10,080 | 53 |
| PMA | 4000 | 10,258 | 129 |

### Example 3 (comparative, not according to the invention)

Formulations of MDT in a polyhydroxystyrene-poly-tert-butoxycarbonyloxystyrene copolymer according to U. S. Patent Application, Serial No. 07/322,848, filed March 14, 1989, Attorney Docket No. FI9-88-046, were formulated in PMA and EEP and the film uniformity of the spun cast films were measured on silicon wafers.

| Casting Solvent | RPM | Thickness(A) | Uniformity(3s)in A |
|---|---|---|---|
| EEP | 2000 | 13,482 | 42 |
| PMA | 2000 | 13,589 | 126 |
| | | | |
| EEP | 3000 | 11,367 | 49 |
| PMA | 3000 | 11,874 | 115 |
| | | | |
| EEP | 4000 | 10,478 | 52 |
| PMA | 4000 | 10,352 | 95 |

### Example 4 (comparative, not according to the invention)

Formulations of electron beam resist of polyolefin sulfone and resins according to U. S. Patent No. 4,398,001 were made up in PMA and EEP and the film uniformity of the spun cast films was measured on silicon wafers.

| Casting Solvent | RPM | Thickness(A) | Uniformity(3s)in A |
|---|---|---|---|
| EEP | 2000 | 12,247 | 45 |
| PMA | 2000 | 12,469 | 134 |
| | | | |
| EEP | 3000 | 11,368 | 46 |
| PMA | 3000 | 11,689 | 104 |
| | | | |
| EEP | 4000 | 10,542 | 42 |
| PMA | 4000 | 10,742 | 96 |

The EEP formulations were consistently more uniform at the same and over a wider rpm range than PMA or PMA/PMM formulations. High film uniformity minimizes linewidth distortion across the exposed wafer. In addition, the minimum volume necessary to coat a 200 mm wafer was 2 mL while 4-5 mL were required for the same spread/spin cycle. Also EEP formulations were able to be cast to acceptable films over a wider rpm range than PMA cast films reducing the number of formulations that need to be manufactured to cover ranges of resist film thickness. This results in cost savings and reduced inventory. The shelf life of EEP and PMA formulations were measured at 35°C, 45°C and 54°C accelerated aging. Both EEP and PMA formulations of Example 1 has a shelf life of 6 months at 25°C with no detectable change in photospeed or particle formulation.

## Claims

1. A photoresist composition which is spin-appliable to form a film of uniform thickness comprising:
(a) a polymeric resin
(b) a diazoquinone sulfonyl ester of 4,8-bis(hydroxymethyl)-tricyclo-[5.2.1.0^{2,6}]decane as the a photoactive compound, and
(c) an ethyl-3-ethoxypropionate solvent wherein the thickness of the coating is extremely uniform.

2. The photoresist composition of claim 1 wherein the said ethyl-3-ethoxypropionate solvent is present in an amount from 40-99.9% by weight of the photoresist composition.

3. The photoresist composition of Claim 1 or 2 wherein the polymeric resin is a phenol-aldehyde resin or a polyhydroxystyrene copolymer.

4. The photoresist composition of Claim 1, 2 or 3 which further comprises an additional component selected from the group of dyes, antistriation agents, plasticizers, adhesion promoters, speed enhancers, solvents and surfactants.

5. A method for uniform application of a radiation sensitive composition to semiconductor wafers comprising the steps of:
a) preparing a radiation sensitive composition comprising an alkaline soluble polymeric resin and a diazoquinone sulfonyl ester of 4,8-bis(hydroxymethyl)-tri-cyclo[5.2.1.0^{2,6}]decane photoactive compound dissolved in ethyl-3-ethoxypropionate,
b) spin coating said composition onto a semiconductor wafer.

6. The method of Claim 5 wherein said radiation sensitive composition further comprises an additional component selected from the group of dyes, antistriation agents, plasticizers, adhesion promoters, speed enhancers, solvents, and surfactants.

7. The method of Claim 5 or 6 wherein said ethyl-3-ethoxypropionate is present from about 40-99.9% by weight of said radiation sensitive composition.

8. The method of Claim 5, 6 or 7 wherein said resin is a phenol-aldehyde resin or a polyhydroxystyrene copolymer.

## Patentansprüche

1. Eine Photoresist-Zusammensetzung, die schleuderaufschichtbar ist, um eine Dünnschicht gleichmäßiger Dicke auszubilden, bestehend aus:
(a) Einem Polymerharz;
(b) einem 4,8-bis(Hydroxymethyl)-tricyclo-[5.2.1.0^{2,6}]-dekan-diazochinonsulfonylester als lichtaktive Verbindung; und
(c) einem Ethyl-3-ethoxypropionat-Lösungsmittel, in dem die Dicke der Beschichtung extrem gleichmäßig ist.

2. Die Photoresist-Zusammensetzung gemäß Anspruch 1, in der das Ethyl-3-ethoxypropionat-Lösungsmittel in einer Menge von 40 - 99,9 Gew.% der Photoresist-Zusammensetzung vorkommt.

3. Die Photoresist-Zusammensetzung gemäß Anspruch 1 oder 2, in der das Polymerharz ein Phenolaldehyd-Harz oder ein Polyhydroxystyrol-Copolymer ist.

4. Die Photoresist-Zusammensetzung gemäß Anspruch 1, 2 oder 3, das ferner eine zusätzliche Komponente enthält, die aus der Gruppe der Farben, Antistreifenbildungsagentien, Weichmacher, Haftverbesserer, Beschleuniger, Lösungsmittel und Tenside ausgewählt wird.

5. Ein Verfahren zum gleichmäßigen Auftragen einer strahlenempfindlichen Zusammensetzung auf Halbleiter-Wafer, das die folgenden Schritte umfaßt:
a) Herstellen einer strahlenempfindlichen Zusammensetzung, enthaltend ein alkalisches lösliches Polymerharz und eine lichtempfindliche 4,8-bis(Hydroxymethyl)-tricyclo-[5.2.1.0^{2,6}]-dekan- diazochinonsulfonylester-Verbindung, gelöst in Ethyl-3-ethoxypropionat;
b) Schleuderbeschichten eines Halbleiter-Wafers mit dieser Zusammensetzung.

6. Das Verfahren gemäß Anspruch 5, in dem die strahlenempfindliche Zusammensetzung ferner eine zusätzliche Komponente beinhaltet, die aus der Gruppe der Farben, Antistreifenbildungsagentien, Weichmacher, Haftverbesserer, Beschleuniger, Lösungsmittel und Tenside ausgewählt wird.

7. Das Verfahren gemäß Anspruch 5 oder 6, in dem das Ethyl-3-ethoxypropionat-Lösungsmittel in einer Menge von etwa 40 - 99,9 Gew.% der strahlenempfindlichen Photoresist-Zusammensetzung vorkommt.

8. Das Verfahren gemäß Anspruch 5, 6 oder 7, in dem das Harz ein Phenolaldehyd-Harz oder ein Polyhydroxystyrol-Copolymer ist.

## Revendications

1. Composition de résine photosensible qui est applicable à la tournette afin de former un film d'épaisseur uniforme comprenant :
(a) une résine polymèrique
(b) un sulfonyl ester de diazoquinone du 4, 8 - bis (hydroxyméthyl) - tricyclo -[5.2.1.0^{2,6}] decane en tant que composé photosensible, et
(c) un solvant d'éthoxy-3 proprionate d'éthyle dans lequel l'épaisseur du revêtement est extrêmement uniforme.

2. Composition de résine photosensible selon la revendication 1 dans laquelle ledit solvant d'éthoxy-3 proprionate d'éthyle est présent dans une proportion allant de 40 à 99,9 % en poids de la composition de la résine photosensible.

3. Composition de résine photosensible selon la revendication 1 ou 2 dans laquelle la résine polymèrique est une résine phénolaldehyde ou un copolymère de polyhydroxystyrène.

4. Composition de résine photosensible selon la revendication 1, 2 ou 3 qui comprend en outre un composant supplémentaire choisi parmi le groupe constitué des colorants, des agents anti-striation, des plastifiants, des promoteurs d'adhérence, des améliorants de vitesse, des solvants et des agents de surface.

5. Procédé d'application uniforme d'une composition sensible aux rayonnements sur des tranches de semi-conducteurs comprenant les étapes consistant à :
a) préparer une composition sensible aux rayonnements comprenant une résine polymèrique soluble dans une solution alcaline et un composé photosensible de sulfonyl ester de diazoquinone du 4, 8 - bis (hydroxyméthyl) - tricyclo[5.2.1.0^{2,6}] décane dissout dans l'éthoxy-3 propionate d'éthyle,
b) déposer à la tournette ladite composition sur une tranche de semi-conducteur.

6. Procédé selon la revendication 5 dans lequel ladite composition sensible aux rayonnements comprend en outre un composant supplémentaire sélectionné parmi le groupe constitué des colorants, des agents anti-striation, des plastifiants, des promoteurs d'adhérence, des améliorants de vitesse, des solvants, et des agents de surface.

7. Procédé suivant la revendication 5 ou 6 dans lequel ledit éthoxy-3 propionate d'éthyle est présent entre environ 40 à 99,9 % en poids de ladite composition sensible aux rayonnements.

8. Procédé selon la revendication 5, 6 ou 7 dans lequel ladite résine est une résine phénol-aldhyde ou un copolymère de polyhydroxystyrène.
